# FASCICULE DE BREVET EUROPEEN

(11) **EP 0 785 706 B1**
(45) Date de publication et mention de la délivrance du brevet: **20.08.2003**
(21) Numéro de dépôt: 97400051.5
(22) Date de dépôt: 13.01.1997
(51) Int. Cl.: H05K 7/14

(54) **Tiroir pour cartes électroniques à embrochement et débrochage automatiques et tiroir et son coffre et procédé de démontage de cartes électroniques**
Einschub für elektronische Karten mit automatischem Einstecken und Trennen, Einschub und seine Aufnahmestruktur, Demontageverfahren von elektronischen Karten
Drawer for electronic cards with automatic plug-in and draw-out, drawer and its receptacie and method for dismounting electronic cards

(30) Priorité: 19.01.1996 FR 9600587
(43) Date de publication de la demande: 23.07.1997
(73) Titulaire: GEC ALSTHOM TRANSPORT SA, 75116 Paris (FR)
(72) Inventeur: Ruque, Christian, 69960 Corbas (FR)
(74) Mandataire: Gosse, Michel

(56) Documents cités:
- EP-A- 0 710 065
- WO-A-91/10343
- DE-A- 3 603 643
- US-A- 4 179 724

## Description

La présente invention concerne les ensembles de support de cartes électroniques, en général, et porte, plus particulièrement, sur un tiroir pour cartes électroniques à embrochement et débrochage automatiques et sur un tiroir et son coffre, ainsi que sur un procédé de démontage de cartes électroniques.

Dans le tiroir pour cartes électroniques de l'état de la technique, les cartes filles sont indépendantes et sont montées dans un tiroir par l'avant de celui-ci.

Les cartes filles possèdent sur leur côté arrière un connecteur arrière et sur leur côté avant un connecteur avant.

Les cartes filles sont susceptibles d'être embrochées manuellement au moyen de connecteurs disposés sur une carte mère disposée à l'arrière du tiroir.

La carte mère a pour fonction la réalisation des liaisons électriques entre cartes filles.

Une fois les cartes filles embrochées à l'arrière du tiroir, un câblage mobile est susceptible d'être connecté manuellement à l'avant du tiroir sur les cartes filles au moyen de connecteurs munis de fiches.

Une telle architecture d'un tiroir pour cartes électroniques à pour inconvénients:
- de nécessiter un temps assez long pour sortir le tiroir complet, en effet il est nécessaire de démonter tous les connecteurs disposés à l'avant,
- de nécessiter un important volume d'implantation du fait de la présence de fiches de maintien des câbles, du fait d'un volume important de dégagement des câbles et des fiches, du fait des surlongueurs de câbles pour effectuer ces dégagements,
- que les câbles disposés a l'avant du tiroir subissent à chaque sortie du tiroir des effets de torsions d'où un risque de détérioration de ces câblages lors des différentes manipulation du tiroir,
- d'enlever les connecteurs avant et de disposer des connecteurs de test sur la face avant du tiroir,
- de rendre problématique la visualisation des voyants disposés à l'avant des cartes filles,
- que la mise à la masse des fils blindés est difficile du fait du manque de place dans les fiches et du fait que le raccordement à l'extérieur des fiches nécessite des longueurs de câbles importantes d'où une impédance élevée,
- des surcoûts importants.

Le document Wo 91/10343 porte sur un tiroir pour cartes électroniques, les cartes électroniques étant connectées sur une carte mère au moyen de connecteurs de cartes et les cartes électroniques étant connectées à des connecteurs de sortie.

Un tel tiroir de l'art antérieur présente également les inconvénients cités ci-dessus.

Aussi un but de l'invention est-il un tiroir pour cartes électroniques à embrochement et débrochage automatiques permettant de s'adapter aux contraintes d'architecture électronique nouvelles et ne présentant pas les inconvénients des tiroir de l'état de la technique.

Par contraintes d'architecture électronique nouvelles il faut comprendre le fait que l'on ne souhaite pas mélanger les signaux électriques dits propres et les signaux électriques dits sales.

Conformément à l'invention, le tiroir pour cartes électroniques, lesdites cartes électroniques étant connectées sur une carte mère au moyen de connecteurs de cartes et lesdites cartes électroniques étant connectées à des connecteurs de sortie, se caractérise en ce que ledit tiroir est à embrochement et débrochage automatiques et en ce que sont disposés successivement de l'arrière à l'avant dudit tiroir:
- lesdits connecteurs de sortie arrière, disposés à l'intérieur d'un support de tiroir et solidaires de la face arrière dudit support de tiroir,
- lesdites cartes électroniques, disposées entre lesdits connecteurs de sortie arrière et lesdits connecteurs de cartes avant, et
- ladite carte mère, disposée à proximité de la face avant dudit tiroir.

Lesdites cartes électroniques disposées entre lesdits connecteurs de sortie arrière et lesdits connecteurs de cartes avant sont susceptibles d'être déconnectés manuellement par l'arrière de ladite carte mère du fait des connecteurs de cartes avant.

Conformément à une autre caractéristique de l'invention, ledit tiroir est susceptible d'être inséré dans un coffre dans lequel:
- un câblage de sortie est disposé à l'arrière dudit coffre, et
- des connecteurs de sortie associés sont disposés à l'intérieur dudit coffre et sont solidaires de la face arrière dudit coffre.

Le tiroir et son coffre de l'invention satisfont également à la caractéristique selon laquelle lesdites cartes électroniques sont connectées/déconnectées audit/dudit câblage de sortie au moyen desdits connecteurs de sortie associés par l'intermédiaire desdits connecteurs de sortie arrière, lesdits connecteurs de sortie associés et lesdits connecteurs de sortie arrière se faisant face, la connexion/déconnexion desdites cartes électroniques auxdits connecteurs de sortie associés se faisant simultanément par embrochement/débrochage desdits connecteurs de sortie associés et desdits connecteurs de sortie arrière.

Conformément à l'invention, le procédé de démontage de cartes électroniques connectées sur une carte mère, se caractérise en ce que lesdites cartes électroniques étant connectées à des connecteurs de sortie arrière, lesdites cartes électroniques sont susceptibles d'être connectées/déconnectées simultanément auxdits/desdits connecteurs de sortie associés par embrochement/débrochage desdits connecteurs de sortie arrière et lesdites cartes électroniques sont susceptibles d'être déconnectés manuellement par l'arrière de ladite carte mère au moyen desdits connecteurs de cartes avant.

Un avantage du tiroir pour cartes électroniques à embrochement et débrochage automatiques de l'invention est de ne plus nécessiter de démontage des connecteurs avant d'où un gain de temps important lors du démontage du tiroir.

Un autre avantage du tiroir pour cartes électroniques à embrochement et débrochage automatiques de l'invention est une réduction du volume d'implantation au minimum du fait de la suppression des fiches, du volume de dégagement et des surlongueurs de câbles.

Un autre avantage du tiroir pour cartes électroniques à embrochement et débrochage automatiques de l'invention est l'absence de risques de détérioration des câbles et des connecteurs du fait que le câblage et les connecteurs ne sont plus démontés.

Un autre avantage du tiroir pour cartes électroniques à embrochement et débrochage automatiques de l'invention est une visualisation et une accessibilité parfaite au niveaux des voyants et des points de tests du fait de l'absence de câble et de connecteurs en face avant du tiroir.

Un autre avantage du tiroir pour cartes électroniques à embrochement et débrochage automatiques de l'invention est une accessibilité parfaite des carte électroniques dans le tiroir du fait que la fixation mécanique des cartes se fait lorsque le tiroir est démonté de son support.

Un autre avantage du tiroir pour cartes électroniques à embrochement et débrochage automatiques de l'invention est de résoudre parfaitement le problème des perturbations électromagnétiques en utilisant un support de tiroir conducteur.

Un autre avantage du tiroir pour cartes électroniques à embrochement et débrochage automatiques de l'invention est que la mise à la masse des fils blindés ne pose plus de problème particulier du fait que le blindage du câblage fixe peut être raccourci au maximum par rapport aux connecteurs et que le raccordement de ce blindage peut se faire directement sur le coffre.

D'autres buts, caractéristiques et avantages de l'invention apparaîtront à la lecture de la description du mode de réalisation préféré du tiroir pour cartes électroniques à embrochement et débrochage automatiques, ainsi que du procédé de démontage de cartes électroniques, description faite en liaison avec les dessins dans lesquels:
- la figure 1 est une vue de dessus du tiroir pour cartes électroniques et de son coffre de l'état de la technique,
- la figure 2 est une vue de dessus du tiroir pour cartes électroniques à embrochement et débrochage automatiques et de son coffre conformes à l'invention,
- la figure 3 est une vue de dessus du tiroir pour cartes électroniques à embrochement et débrochage automatiques et de son coffre selon un deuxième mode de réalisation de l'invention,
- la figure 4 est une vue de dessus du tiroir pour cartes électroniques à embrochement et débrochage automatiques et de son coffre selon un troisième mode de réalisation de l'invention, et
- la figure 5 est une vue de dessus du tiroir pour cartes électroniques à embrochement et débrochage automatiques et de son coffre selon un quatrième mode de réalisation de l'invention.

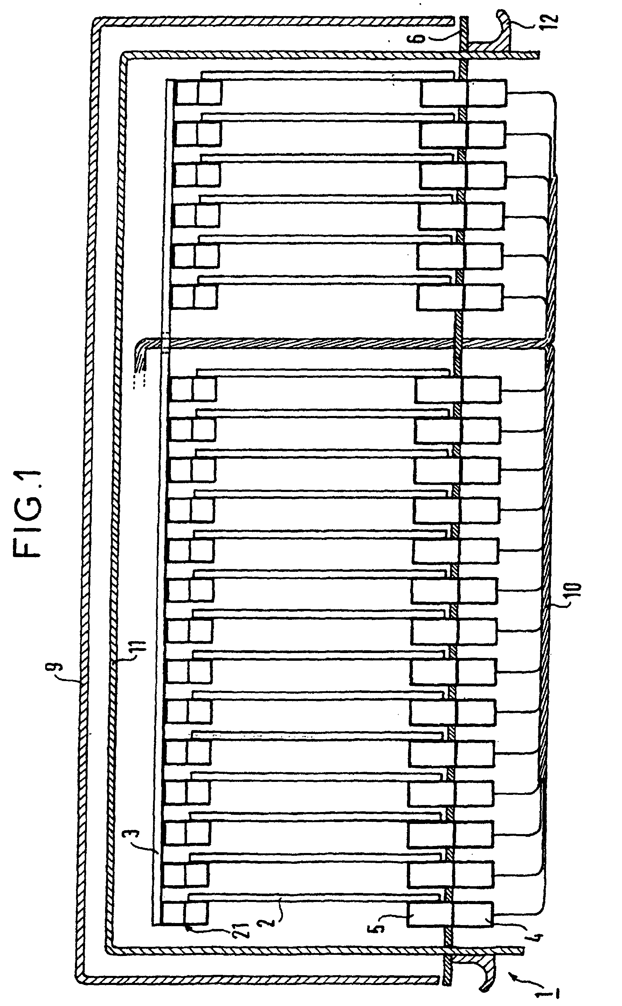

La figure 1 est une vue de dessus du tiroir pour cartes électroniques et de son coffre de l'état de la technique.

Le tiroir représenté sur cette figure 1 est décrit précédemment.

Le tiroir 1 pour cartes électroniques 2 comporte des cartes électroniques, appelées cartes électroniques filles, connectées sur une carte mère 3.

Ces cartes électroniques 2 sont connectées sur la carte mère 3 au moyen de connecteurs 21 de cartes.

Les connecteurs 21 de cartes permettent un embrochement manuel des cartes filles 2 lors de leur rentrée dans le tiroir.

Ces connecteurs 21 de cartes ont pour fonction de réaliser les liaisons électriques entre cartes filles par l'intermédiaire de la carte mère 3.

La carte mère 3 est disposée parallèlement à la face arrière du support 11 de tiroir 1 et proche de cette face arrière.

Le tiroir 1 pour cartes électroniques comporte des cartes filles 2 sur le côté avant desquelles sont fixés des connecteurs de sortie 5.

Des connecteurs de sortie 4 associés sont susceptibles d'être connectés manuellement aux connecteurs de sortie 5.

Ces connecteurs de sortie 4 associés sont solidaires d'un câblage de sortie 10 mobile.

Les connecteurs de sortie 4, 5 ont pour fonction de réaliser les liaisons électriques entre les cartes filles et le câblage de sortie 10 mobile.

La réalisation du tiroir pour cartes électroniques de l'état de la technique nécessite de fixer la carte mère sur l'arrière du tiroir.

Le tiroir pour cartes électroniques comporte également des moyens de préhension 12 solidaires de la face avant 6 du tiroir 1.

Ces moyens de préhension 12 sont, par exemple, des poignées ou encore des fenêtres respectivement fixées ou pratiquées sur la face avant 6 du tiroir 1.

Le tiroir 1 pour cartes électroniques est mis en place et est fixé mécaniquement dans un coffre 9.

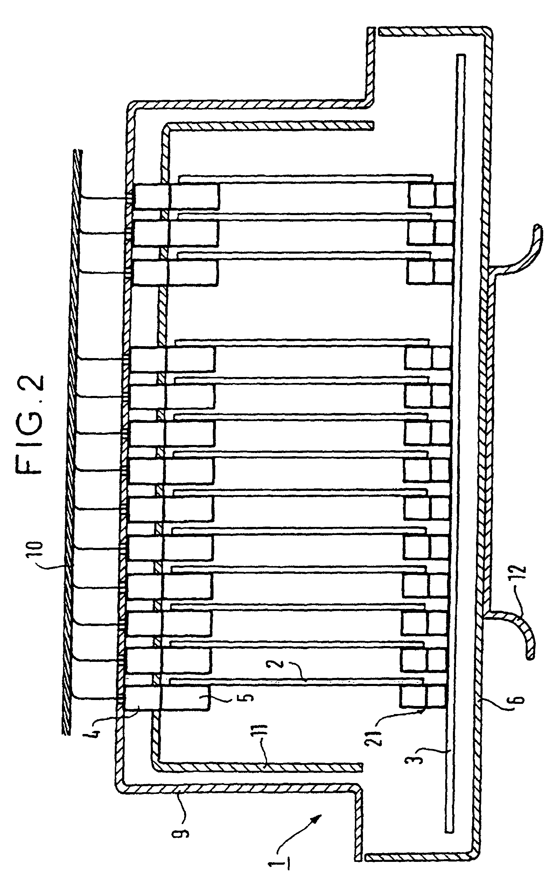

La figure 2 est une vue de dessus du tiroir pour cartes électroniques à embrochement et débrochage automatiques et de son coffre conformes à l'invention.

Le tiroir 1 pour cartes électroniques 2 comporte des cartes électroniques, appelées cartes électroniques filles, connectées sur une carte mère 3.

Ces cartes électroniques 2 sont connectées manuellement sur la carte mère 3 au moyen de connecteurs de cartes 21.

Comme indiqué précédemment, les connecteurs 21 de cartes ont pour fonction de réaliser les liaisons électriques entre cartes filles par l'intermédiaire de la carte mère 3.

La carte mère 3 est disposée parallèlement à la face avant 6 du tiroir 1.

Le tiroir 1 pour cartes électroniques comporte des cartes filles 2 sur le côté arrière desquelles sont fixés des connecteurs de sortie 5.

Des connecteurs de sortie 4 associés sont susceptibles d'être connectés automatiquement aux connecteurs de sortie 5.

Ces connecteurs de sortie 4 associés sont solidaires d'un câblage de sortie 10 fixe.

Les connecteurs de sortie 4, 5 permettent un embrochement automatique des cartes filles 3 lors de leur rentrée dans le tiroir.

Comme indiqué précédemment, les connecteurs de sortie 4, 5 ont pour fonction de réaliser les liaisons électriques entre les cartes filles et le câblage de sortie 10 mobile.

La réalisation du tiroir pour cartes électroniques de l'invention nécessite de fixer la carte mère sur l'avant du tiroir.

Le tiroir pour cartes électroniques comporte également des moyens de préhension 12 solidaires de la face avant 6 du tiroir 1.

Ces moyens de préhension 12 sont, par exemple, des poignées ou encore des fenêtres respectivement fixées ou pratiquées sur la face avant 6 du tiroir 1.

Les connecteurs de sortie 5 sont solidaires de la face arrière du support 11 de tiroir 1.

Les connecteurs de sortie 4 associés solidaires du câblage de sortie 10 fixe sont solidaires de la face arrière du coffre 9.

La face avant 6 du tiroir 1 et le support 11 de tiroir 1 sont reliées mécaniquement l'une à l'autre de manière à former un tiroir de structure indéformable.

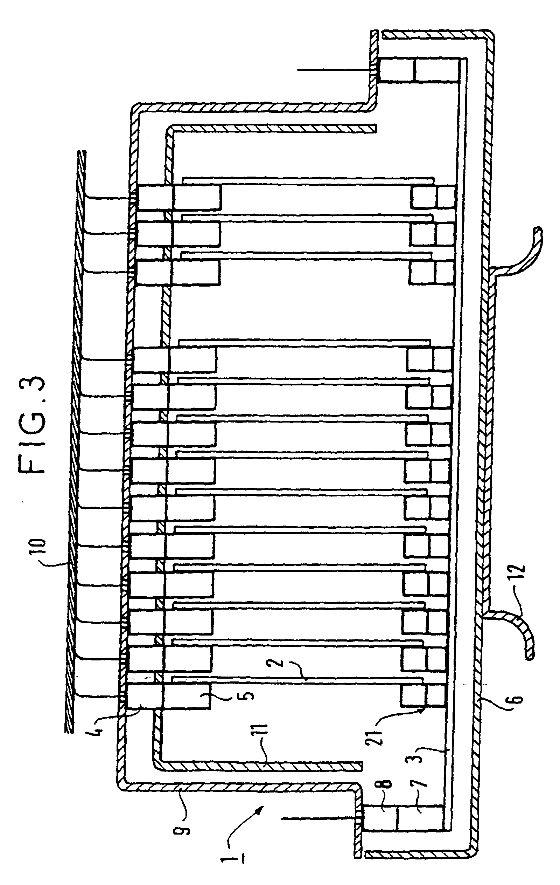

La figure 3 est une vue de dessus du tiroir pour cartes électroniques à embrochement et débrochage automatiques et de son coffre selon un deuxième mode de réalisation de l'invention.

Le tiroir pour cartes électroniques à embrochement et débrochage automatiques et son coffre selon le deuxième mode de réalisation de l'invention sont identiques au tiroir pour cartes électroniques à embrochement et débrochage automatiques et au support selon le premier mode de réalisation de l'invention.

Le tiroir pour cartes électroniques à embrochement et débrochage automatiques selon ce deuxième mode de réalisation comporte, en plus des connecteurs de sorties arrière 4, 5, des connecteurs de sortie latérale 7, 8.

Dans ce deuxième mode de réalisation la carte mère 3 est prolongée de part et d'autre des cartes filles 2 et les extrémités libres de la carte mère sont ainsi susceptibles de comporter des connecteurs de sorties 7, 8.

Les connecteurs de sorties 8 fixes sont solidaires du coffre 9.

Les cartes filles étant connectées à la carte mère, la connexion des cartes filles aux connecteurs de sortie arrière 4 et la connexion de la carte mère aux connecteurs de sortie latérale 8 sont réalisées en même temps, lors de l'insertion du tiroir dans son coffre.

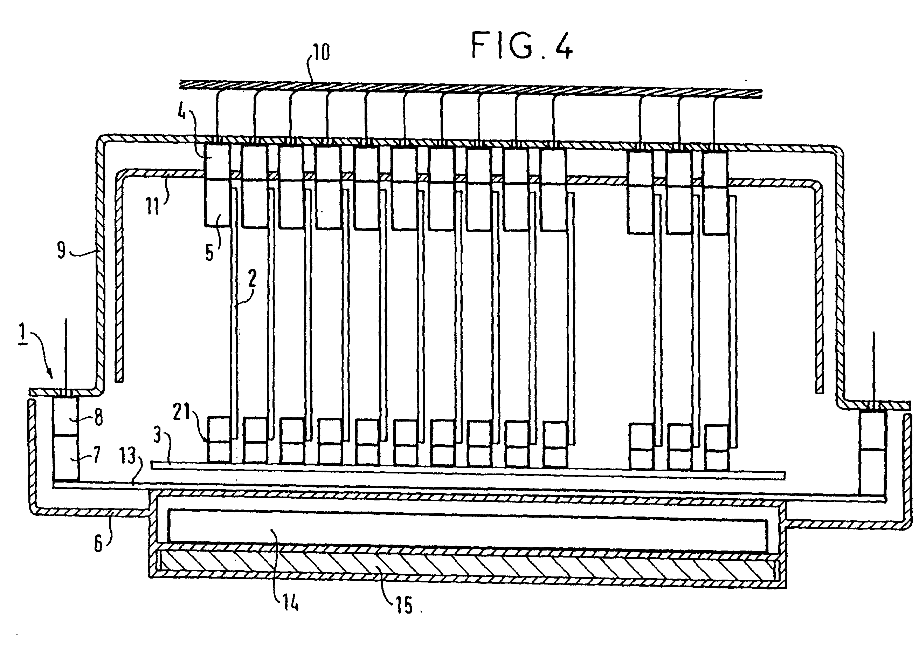

La figure 4 est une vue de dessus du tiroir pour cartes électroniques à embrochement et débrochage automatiques et de son coffre selon un troisième mode de réalisation de l'invention.

Le tiroir pour cartes électroniques à embrochement et débrochage automatiques et son support selon le deuxième mode de réalisation de l'invention sont identiques au tiroir pour cartes électroniques à embrochement et débrochage automatiques et au support selon le premier mode de réalisation de l'invention.

Le tiroir pour cartes électroniques à embrochement et débrochage automatiques selon ce troisième mode de réalisation comporte, en plus de la carte mère 3, une seconde carte mère 13 et comporte, en plus des connecteurs de sorties arrière 4, 5, des connecteurs de sortie latérale 7, 8.

Cette seconde carte mère 13 est disposée entre la première carte mère 3 et la face avant 6 du tiroir. Dans ce troisième mode de réalisation la seconde carte mère 13 est prolongée de part et d'autre de la première carte mère 3 et les extrémités libres de la seconde carte mère 13 sont ainsi susceptibles de comporter des connecteurs de sorties 7, 8.

Les connecteurs de sorties 8 fixes sont solidaires du coffre 9.

Comme précédemment, les cartes filles étant connectées à la première carte mère, la connexion des cartes filles aux connecteurs de sortie arrière 4 et la connexion de la seconde carte mère 13 aux connecteurs de sortie latérale 8 sont réalisées en même temps lors de l'insertion du tiroir dans son coffre.

Cette seconde carte mère a pour intérêt de permettre la réception et l'émission de signaux électriques d'un côté de la seconde carte mère ou de l'autre.

Des composants de puissance 14 peuvent être disposés sur la seconde carte mère 13 de manière à apparaître sur la face avant du tiroir.

Le refroidissement de ces composants de puissance est obtenu du fait que ces composants de puissance sont dirigés vers l'extérieur du tiroir.

Le refroidissement de ces composants de puissance peut être amélioré au moyen d'un dispositif de refroidissement 15, par exemple un radiateur, disposé sur les composants de puissance à l'extérieur de la face avant du tiroir.

Un avantage du tiroir pour cartes électroniques à embrochement et débrochage automatiques selon le troisième mode de réalisation est d'être parfaitement adapté aux dispositifs d'alimentation, qui sont généralement des dispositifs lourds.

Un autre avantage du tiroir pour cartes électroniques à embrochement et débrochage automatiques selon le troisième mode de réalisation est d'avoir un centre de gravité proche de l'avant du tiroir d'où une manipulation du tiroir plus facile.

Un autre avantage du tiroir pour cartes électroniques à embrochement et débrochage automatiques selon le troisième mode de réalisation est de permettre, moyennant un aménagement, à la portée de l'homme du métier, de la structure mécanique avant du tiroir, de rendre monobloc l'ensemble disposé à l'avant du tiroir de manière à démonter cette ensemble indépendamment du reste du tiroir.

La carte mère 3 peut comporter des connecteurs de sortie latérale 7, 8 comme décrit précédemment en liaison avec la figure 3 ou ne pas comporter de tels connecteurs de sortie latérale 7, 8.

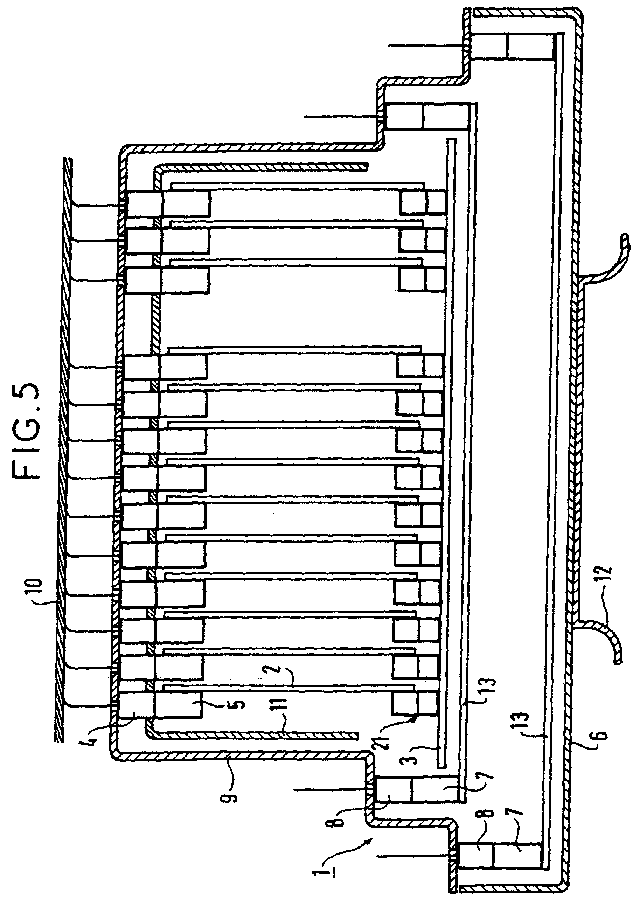

La figure 5 est une vue de dessus du tiroir pour cartes électroniques à embrochement et débrochage automatiques et de son coffre selon un quatrième mode de réalisation de l'invention.

Le tiroir pour cartes électroniques à embrochement et débrochage automatiques et son support selon le quatrième mode de réalisation de l'invention sont identiques au tiroir pour cartes électroniques à embrochement et débrochage automatiques et au support selon le premier mode de réalisation de l'invention.

Le tiroir pour cartes électroniques à embrochement et débrochage automatiques selon ce quatrième mode de réalisation comporte, en plus de la carte mère 3, plusieurs cartes mères 13 supplémentaires et comporte, en plus des connecteurs de sorties arrière 4, 5 des connecteurs de sortie latérale 7, 8.

Les cartes mères 13 supplémentaires sont disposées entre la première carte mère 3 et la face avant 6 du tiroir.

Dans ce quatrième mode de réalisation une carte mère 13 supplémentaire donnée est prolongée de part et d'autre de la carte mère disposée directement au-dessus d'elle et les extrémités libres de cette carte mère 13 supplémentaire donnée sont ainsi susceptibles de comporter des connecteurs de sorties 7, 8.

Les connecteurs de sorties 8 fixes sont solidaires du coffre 9.

Comme précédemment, les cartes filles étant connectées à la première carte mère, la connexion des cartes filles aux connecteurs de sortie arrière 4 et la connexion des cartes mères 13 supplémentaires aux connecteurs de sortie latérale 8 sont réalisées en même temps lors de l'insertion du tiroir dans son coffre.

Les cartes mères 13 supplémentaires sont disposées les unes au dessus des autres de manière à former un ensemble de forme générale pyramidale sur au moins un de ses côtés.

La carte mère 3 peut comporter des connecteurs de sortie latérale 7, 8 comme décrit précédemment en liaison avec la figure 3 ou ne pas comporter de tels connecteurs de sortie latérale 7, 8.

Il résulte de ce qui précède un procédé de démontage de cartes électroniques (2) connectées sur une carte mère (3), les cartes électroniques (2) étant connectées à des connecteurs de sortie (5) arrière.

Les cartes électroniques (2) sont susceptibles d'être connectées/déconnectées simultanément aux/des connecteurs de sortie associés (4) par embrochement/débrochage des connecteurs de sortie (5) arrière.

Les cartes électroniques (2) sont également susceptibles d'être déconnectés manuellement par l'arrière de la carte mère (3) au moyen des connecteurs de cartes (21) avant.

## Revendications

1. Tiroir (1) pour cartes électroniques (2), lesdites cartes électroniques (2) étant connectées sur une carte mère (3) au moyen de connecteurs de cartes (21) et lesdites cartes électroniques (2) étant connectées à des connecteurs de sortie (5), **caractérisé en ce que** ledit tiroir (1) est à embrochement et débrochage automatiques et **en ce que** lesdits connecteurs de sortie, lesdites cartes électroniques et ladite carte mère sont disposés successivement de l'arrière à l'avant dudit tiroir (1):
- lesdits connecteurs de sortie (5) arrière, étant disposés à l'intérieur d'un support (11) de tiroir (1) et solidaires de la face arrière dudit support (11) de tiroir (1),
- lesdites cartes électroniques (2) étant disposées entre lesdits connecteurs de sortie (5) arrière et lesdits connecteurs de cartes (21) avant, et
- ladite carte mère (3) étant disposée à proximité de la face avant (6) dudit tiroir (1).

2. Tiroir selon la revendication 1, dans lequel lesdites cartes électroniques (2) disposées entre lesdits connecteurs de sortie (5) arrière et lesdits connecteurs de cartes (21) avant sont susceptibles d'être déconnectés manuellement par l'arrière de ladite carte mère (3) du fait des connecteurs de cartes (21) avant.

3. Tiroir (1) selon l'une quelconque des revendications précédentes, ledit tiroir étant susceptible d'être inséré dans un coffre (9) dans lequel:
- un câblage de sortie (10) est disposé à l'arrière dudit coffre (9), et
- des connecteurs de sortie associés (4) sont disposés à l'intérieur dudit coffre (9) et sont solidaires de la face arrière dudit coffre (9).

4. Tiroir (1) et son coffre (9) selon la revendication 3, dans lequel lesdites cartes électroniques (2) sont connectées/déconnectées audit/dudit câblage de sortie (10) au moyen desdits connecteurs de sortie associés (4) par l'intermédiaire desdits connecteurs de sortie (5) arrière, lesdits connecteurs de sortie associés (4) et lesdits connecteurs de sortie (5) arrière se faisant face, la connexion/déconnexion desdites cartes électroniques (2) auxdits connecteurs de sortie associés (4) se faisant simultanément par embrochement/débrochage desdits connecteurs de sortie associés (4) et desdits connecteurs de sortie (5) arrière.

5. Procédé de démontage de cartes électroniques (2) connectées sur une carte mère (3) au moyen d'un tiroir pour cartes étectroniques selon la revendication 1, **caractérisé en ce que** lesdites cartes électroniques (2) étant connectées à des connecteurs de sortie (5) arrière, lesdites cartes électroniques (2) sont susceptibles d'être connectées/déconnectées simultanément aux/des connecteurs de sortie associés (4) par embrochement/débrochage desdits connecteurs de sortie (5) arrière et lesdites cartes électroniques (2) sont susceptibles d'être déconnectés manuellement par l'arrière de ladite carte mère (3) au moyen des connecteurs de cartes (21) avant.

## Patentansprüche

1. Einschub (1) für elektronische Karten (2), wobei die elektronischen Karten (2) mittels Steckverbindern (21) auf einer Hauptplatine (3) angeschlossen sind und die elektronischen Karten (2) an Ausgangsbuchsen (5) angeschlossen sind, **dadurch gekennzeichnet, dass** der Einschub (1) mit automatischem Einstecken und Trennen erfolgt und dass die Ausgangsbuchsen, die elektronischen Karten und die Hauptplatine nacheinander von hinten nach vorne im Einschub (1) angeordnet sind (1), wobei :
- die Ausgangsbuchsen (5) hinten in einem Halter (11) des Einschubs (1) und verbunden mit der Rückseite des Halters (11) des Einschubs (1) angeordnet sind,
- die elektronischen Karten (2) zwischen den Ausgangsbuchsen (5) hinten und den Steckverbindern (21) vorn angeordnet sind und
- die Hauptplatine (3) in unmittelbarer Nähe der Vorderseite (6) des Einschubs (1) angeordnet ist.

2. Einschub nach Anspruch 1, wobei die elektronischen Karten (2), die zwischen den Ausgangsbuchsen (5) hinten und den Steckverbindern (21) vorn angeordnet sind, aufgrund der Steckverbinder (21) vorn an der Hauptplatine von hinten manuell herausgezogen bzw. unterbrochen werden können.

3. Einschub (1) nach einem der vorhergehenden Ansprüche, wobei der Einschub in eine Aufnahmestruktur (9) eingesetzt werden kann, wobei:
- im hinteren Teil der Aufnahmestruktur (9) eine Anschlussverdrahtung (10) angeordnet ist, und
- strukturell ähnliche Ausgangsbuchsen (4) im Innern der Aufnahmestruktur (9) angeordnet sind und mit der Rückseite der Aufnahmestruktur (9) verbunden sind.

4. Einschub (1) und seine Aufnahmestruktur (9) nach Anspruch 3, wobei die elektronischen Karten (2) mittels der strukturell ähnlichen Ausgangsbuchsen (4) durch die Ausgangsbuchsen (5) hinten mit der Anschlussverdrahtung verbunden bzw. von ihr getrennt werden, wobei die strukturell ähnlichen Ausgangsbuchsen (4) und die Ausgangsbuchsen (5) hinten einander zugewandt sind, wobei die Verbindung bzw. Trennung der elektronischen Karten (2) an die bzw. von den strukturell ähnlichen Ausgangsbuchsen (4) gleichzeitig durch Einstecken bzw. Trennen der strukturell ähnlichen Ausgangsbuchsen (4) und der Ausgangsbuchsen (5) hinten erfolgt.

5. Demontageverfahren von elektronischen Karten (2), die auf einer Hauptplatine (3) mittels eines Einschubs für elektronische Karten nach Anspruch 1 angeschlossen sind, **dadurch gekennzeichnet, dass** die elektronischen Karten (2) an Ausgangsbuchsen (5) hinten angeschlossen sind, wobei die elektronischen Karten (2) gleichzeitig durch Einstecken und Trennen der Ausgangsbuchsen (5) hinten mit den strukturell ähnlichen Ausgangsbuchsen (4) verbunden bzw. von ihnen getrennt werden können, und die elektronischen Karten (2) mittels Steckverbindern (21) vorn an der Hauptplatine (3) von hinten manuell herausgezogen bzw. unterbrochen werden können.

## Claims

1. A drawer (1) for electronic cards (2), said electronic cards (2) being connected to a mother board (3) by means of card connectors (21), and said electronic cards (2) being connected to output connectors (5), the drawer (1) being **characterized in that** it is automatically pluggable and unpluggable and **in that** said output connectors, said electronic cards, and said mother board are disposed successively from the back to the front of said drawer (1):
· said back output connectors (5) being disposed inside a drawer support (11) and secured to the back face of said drawer support (11);
· said electronic cards (2) being disposed between said back output connectors (5) and said front card connectors (21); and
· said mother board (3) being disposed close to the front face (6) of said drawer (1).

2. A drawer according to claim 1, in which said electronic cards (2) disposed between said back output connectors (5) and said front card connectors (21) are suitable for being manually disconnected from the back of said mother board (3) by virtue of the front card connectors (21).

3. A drawer (1) according to any preceding claim, said drawer being suitable for being inserted in a bay (9) in which:
· output cabling (10) is disposed at the back of said bay (9); and
· associated output connectors (4) are disposed inside said bay (9) and are secured to the back face of said bay (9).

4. A drawer (1) and a bay (9) therefor according to claim 3, in which said electronic cards (2) are connected/disconnected to/from said output cabling (10) by means of said associated output connectors (4) via said back output connectors (5), said associated output connectors (4) and said back output connectors (5) facing one another, said electronic cards (2) being connected/disconnected to/from said associated output connectors (4) simultaneously by plugging/unplugging said associated output connectors (4) and said back output connectors (5).

5. A method of removing electronic cards (2) connected to a mother board (3) by means of an electronic-card drawer according to claim 1, the method being **characterized in that** said electronic cards (2) are connected to back output connectors (5), said electronic cards (2) are suitable for being connected/disconnected simultaneously to/from the associated output connectors (4) by plugging/unplugging said back output connectors (5) and said electronic cards (2) are suitable for being disconnected manually from the back of said mother board (3) by means of the front card connectors (21).
